# EUROPEAN PATENT APPLICATION

(11) **EP 1 443 655 A1**
(43) Date of publication of application: **04.08.2004**
(21) Application number: 01981214.8
(22) Date of filing: 16.10.2001
(51) Int. Cl.: H03M 13/00

(54) **METHOD FOR TRANSMITTING A DIGITAL MESSAGE AND SYSTEM FOR CARRYING OUT SAID METHOD**

(30) Priority: 22.05.2001 RU 2001113566
(71) Applicant: MORTON FINANCE S.A., Road Town Tortola, British Virgin Island (VG)
(72) Inventor: PLOTNIKOV, Andrey Alexejevich, Vyborg, Leningradskaya obl., 188800 (RU); AKAJEV, Said Kakhsurujevich, Vyborg, Leningradskaya obl., 188800 (RU); VELIKOKHATSKY, Victor Fyodorovich, St. Petersburg, 197101 (RU); LYSY, Vadim Yevgenievich, Vyborg, Leningradskaya obl., 188800 (RU)
(74) Representative: UEXKÜLL & STOLBERG
(86) International application number: PCT/RU2001/000418
(87) International publication number: WO 2002/095952

(57) **Abstract**

The invention relates to telecommunications, in particular to methods and means for transmitting digital messages and can be used for transmitting information through wire channels and telecommunication channels using electromagnetic waves. The use of said channels is simplified by excluding multiplication and division operators from a coding and decoding process. Said invention makes it possible to transmit any messages from elements of Abelian group including code words whose elements are matrixes, polynomials, numbers of mixed-base notation and nonpositional notation. The codes based on the inventive rules pertain to the class of systematic linear block codes. The inventive system for transmitting a digital message comprises an encoder (1), a modulator (2), a transmitter (3), a receiver (4) a demodulator (5) and a decoder (6).

## Description

### FIELD OF THE INVENTION

This invention relates to telecommunications, in particular to methods and means for transmitting digital messages, and can be used for transmitting information through wire channels and telecommunication channels using electromagnetic waves.

### DESCRIPTION OF THE PRIOR ART

A method for transmitting digital message consisting of additive Abelian group elements is known which comprises consecutive steps of encoding digital message, its modulation, its transmission to a communication channel, demodulation of the received signal and its decoding [1].

A system for transmitting digital messages consisting of additive Abelian group elements is known which comprises consecutively connected at the transmitting side an encoder, a modulator and a transmitter and consecutively connected at the receiving side a receiver, a demodulator and a decoder [1].

The known method and system are rather complicated in realization because they use four arithmetic operations for the encoding and decoding process.

### DESCRIPTION OF THE INVENTION

The technical result achieved when using the proposed method and system consists of simplifying their realization by excluding multiplication and division operations from the encoding and decoding process. This provides an opportunity for transmitting any message consisting of Abelian group elements, in particular code words, whose elements are matrixes, polynomials, numbers of mixed-base notation and non-positional notation. The codes organized in accordance with the proposed rules belong to the class of systematic linear block codes.

The above-mentioned technical result is achieved in that in a method for transmitting a digital message consisting of additive Abelian group elements which comprises consecutive steps of encoding the message, its modulation, its transmission into a communication channel, demodulation of the received signal and its decoding, the encoding is done according to the rule Yₙ =Xₖ⊗G, where
Xₖ is vector-row of the initial message consisting of k information elements,
Yₙ is vector-row of the encoded message consisting of k information and m check elements, where m is the smallest integer not less than log ₂ n, n = k+m,
G is generating matrix of operations which consists of k rows and n columns and is produced from a k×k matrix, with operations g⁰ at the diagonal and operations g¹ at other positions, and an additional kxm matrix added to the kxk matrix at its right, non-repeated rows of which are sequences of operations g¹ and g⁰ or operations g¹ and g² chosen from any possible sequences which include not more than (m-2) operations g¹, or a matrix obtained from said generating matrix of operations by rearranging its rows and/or columns,
⊗ is operation of generalized matrix multiplication according to the rule: yⱼ=^{⊕}Σg^{v}ᵢⱼ(xᵢ) for j≤k and yⱼ=g²[^{⊕}Σ g^{v}ᵢⱼ(xᵢ)] for j>k, if the rows of the additional matrix are sequences of operations g¹ and g⁰, or according to the rule: yⱼ=^{⊕}Σg^{v}ᵢⱼ(xᵢ), if the rows in the additional matrix are sequences of operations g¹ and g², where
yⱼ is j-th element of the vector-row for the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for ij-th matrix element,
v = [0, 2], i=[1, k], j=[1, n],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoding of the message Y'ₙ is done by excluding from the vector-row Y'ₙ of the elements which correspond by their numbers to the columns of the check matrix of operations H with one operation g⁰, provided that there is not more than one element, not equal e, in the vector-column S^{T}ₘ produced according to the rule: S^{T}ₘ=H⊗Y'ₙ^{T}, where
Y'ₙ^{T} is transposed vector-row Y'ₙ, and
H is m×n check matrix of operations produced by transposition of an additional matrix, by adding at its right an m×m matrix with operations g⁰ at its diagonal and operations g¹ at other positions, and by rearranging columns identically to the column rearrangement of the generating matrix of operations, if the rows of the additional matrix are sequences of operations g¹ and g⁰, or in the same way save for changing operations g² for operations g⁰, if the rows of the additional matrix are sequences of operations g¹ and g².

The above-mentioned technical result is also achieved by the fact that before the exclusion from the vector-row Y'ₙ of elements corresponding by their numbers to the columns of the check matrix of operations H, the value of the j-th symbol of the vector-row Y'ₙ is changed by adding it to the inverse element of one of the elements, not equal e, in the vector-column S^{T}ₘ, provided that all elements, not equal e, of the vector-column S^{T}ₘ are identical, and the vector-column S^{T}ₘ converted by changing said elements for operation g⁰ and all other elements for operation g¹, corresponds to the j-th column of the matrix H.

The above-mentioned technical result is also achieved by the fact that under the condition that the message elements belong to a ring with unity, operation g⁰ is multiplication by unity, operation g¹ is multiplication by zero and operation g² is multiplication by minus unity.

The above-mentioned technical result is also achieved by the fact that under the condition that the message elements belong to a residue class ring by modulo q, where q is a natural number, operation ⊕ is the operation of summing by modulo q.

The above-mentioned technical result is also achieved by providing that in a system for transmitting a digital message consisting of additive Abelian group elements which comprises consecutively connected at the transmitting side an encoder, the input of which corresponds to the system's input, a modulator and a transmitter, and consecutively connected at the receiving side a receiver, a demodulator and a decoder, the output of which corresponds to the system's output, the encoder is in a form capable of performing the algorithm Yₙ=Xₖ⊗G, where
Xₖ is vector-row of the initial message consisting of k information elements,
Yₙ is vector-row of the encoded message consisting of k information and m check elements, where m is the smallest integer not less than log ₂ n, n = k+m,
G is generating matrix of operations which consists of k rows and n columns and is produced from a k×k matrix, with operations g⁰ at the diagonal and operations g¹ at other positions, and an additional k×m matrix added to the kxk matrix at its right, non-repeated rows of which are sequences of operations g¹ and g⁰ or operations g¹ and g² chosen from any possible sequences which include not more than (m-2) operations g¹, or a matrix obtained from said generating matrix of operations by rearranging its rows and/or columns,
⊗ is operation of generalized matrix multiplication according to the rule: yⱼ=^{⊕}Σg^{v}ᵢⱼ(xᵢ) for j≤k and yⱼ=g²[^{⊕}Σ g^{v}ᵢⱼ(xᵢ)] for j>k, if the rows of the additional matrix are sequences of operations g¹ and g⁰, or according to the rule: yⱼ=^{⊕}Σg^{v}ᵢⱼ(xᵢ), if the rows in the additional matrix are sequences of operations g¹ and g², where
yⱼ is j-th element of the vector-row for the encoded message,
^{**⊕**}**Σ** g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for ij-th matrix element,
v = [0, 2], i=[1, k], j=[1, n],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoder is in a form which provides for the exclusion from the vector-row Y'ₙ of elements which correspond by their numbers to the columns of the check matrix of operations H with one operation g⁰, provided that there is not more than one element, not equal e, in the vector-column S^{T}ₘ produced according to the rule: S^{T}ₘ=H⊗Y'ₙ^{T}, where
Y'ₙ^{T} is transposed vector-row Y'ₙ, and
H is m×n check matrix of operations produced by transposition of an additional matrix, by adding at its right an m×m matrix with operations g⁰ at its diagonal and operations g¹ at other positions, and by rearranging columns identically to the column rearrangement of the generating matrix of operations, if the rows of the additional matrix are sequences of operations g¹ and g⁰, or in the same way save for changing operations g² for operations g⁰, if the rows of the additional matrix are sequences of operations g¹ and g².

The above-mentioned technical result is also achieved by the fact that the decoder is in a form capable of changing the value of the j-th symbol of the vector-row Y'ₙ by adding it to an inverse element of one of the elements, not equal e, in the vector-column S^{T}ₘ, before the exclusion from the vector-row Y'ₙ of elements corresponding by their numbers to the columns of the check matrix of operations H, provided that all elements, not equal e, of the vector-column S^{T}ₘ are identical, and the vector-column S^{T}ₘ converted by changing said elements for operation g⁰ and all other elements for operation g¹, corresponds to the j-th column of the matrix H.

An above-mentioned technical result is also achieved by providing that the encoder contains:
- the first operative memory unit, k outputs of which are connected to the corresponding first k information inputs of the second operative memory unit, the output of which forms the encoder output,
- a memory unit for operation codes of the generating matrix of operations,
- the first group of m check element calculators, the calculation algorithm control inputs of which are connected to the m corresponding outputs of the memory unit for operation codes of the generating matrix of operations,
- m function g² calculators connected between the corresponding outputs of the first group of m check element calculators and the corresponding (k+1)-th to n-th information inputs of the second operative memory unit,
- consecutively connected the first pulse shape forming unit and the first ring counter up to k, the information input of which is connected to the matrix row address input of the memory unit for operation codes of the generating matrix of operations, and the overflow output of which is connected to the reset inputs of the first operative memory unit and the first group of m check element calculators,
- consecutively connected a pulse generator having recurrent frequency of fn/k, the first switch and the first ring counter up to n, the information output of which is connected to the address input of the second operative memory unit,
- the first gate AND, the output of which is connected to the control input of the first switch,
- the first trigger, the output of which is connected to the direct input of the first gate AND, the inverting input of which is connected with the overflow output of the first ring counter up to n and to the reset input of the first trigger,
- consecutively connected the first pulse recurrent frequency doubler, the input of which is connected to the output of the pulse generator having recurrent frequency of fn/k, and a ring counter up to (2k+1), the overflow output of which is connected to the counting input of the first trigger,
and that the combined inputs of the first operative memory unit and the check element calculators of the first group of m check element calculators, the start input of the pulse shape forming unit and the synchronization input of the pulse generator having recurrent frequency of fn/k together form the encoder input, whereby f is the recurrent frequency of the elements of a digital message.

The above-mentioned technical result is also achieved by providing that the decoder contains:
- the third operative memory unit, the n outputs of which are connected to the n corresponding information inputs of the fourth operative memory unit, the output of which forms the decoder output for a non-correctable message,
- a memory unit for operation codes of the generating matrix of operations,
- the second group of m check element calculators, the calculation algorithm control inputs of which are connected to the m corresponding outputs of the memory unit for operation codes of the generating matrix of operations,
- consecutively connected the second pulse shape forming unit and the second ring counter up to n, the information input of which is connected to the address input of the memory unit for operation codes of the generating matrix of operations, and the overflow output of which is connected to reset inputs of the third operative memory unit and check element calculators of the second group of m check elements calculators,
- consecutively connected a pulse generator with recurrent frequency of fk/n, the second switch, the second ring counter up to k and the third switch, the information output of which is connected to the address input of the fourth operative memory unit,
- a unit for making decisions on decoding, the m inputs of which are connected to the outputs of the corresponding check element calculators of the second group of m check element calculators, and the output of which is connected to the control input of the third switch,
- the second gate AND, the output of which is connected to the control input of the second switch,
- the second trigger, the output of which is connected to the direct input of the second gate AND, the inverting input of which is connected to the overflow output of the second ring counter up to k and to the reset input of the second trigger,
- consecutively connected the second pulse recurrent frequency doubler, the input of which is connected to the output of the pulse generator having recurrent frequency of fk/n, and the ring counter up to [(2(k+1)+1], the overflow output of which is connected to the counting input of the second trigger,
and the combined inputs of the third operative memory unit and check element calculators of the second group of m check element calculators, the start input of the second pulse shape forming unit and the synchronization input of the pulse generator having recurrent frequency of fk/n together form the decoder input.

The above-mentioned technical result is also achieved by connecting the output of the unit for making decisions on decoding to the control input of the third switch through the first gate OR and by providing a unit for making decisions on error correction, the output of which is connected to the second input of the first gate OR, consecutively connected an error calculator, the start input of which is connected to the output of the unit for making decisions on error correction and the writing input of which is connected to the overflow output of the second ring counter up to k, a function g² calculator and an adder for summing up Abelian group elements, the second input of which is connected to the output of the fourth operative memory unit and the output of which forms the correctable message output of the detector, and by providing that m inputs of the unit for making decisions on error correction and m inputs of the error calculator are connected to the outputs of the corresponding check element calculators of the second group consisting of m such calculators.

The above-mentioned technical result is also achieved by providing that the check element calculator contains consecutively connected the fourth switch, a function g¹ calculator, the second gate OR, an accumulating adder of Abelian group elements, the output of which is connected to its second input and the fifth switch, the control input of which forms the reset input and the output of which forms the output of the check element calculator, the sixth switch, the output of which is connected to the second input of the first gate OR, a decipher, the input of which forms the calculation algorithm control input of the check element calculator and the outputs of which are connected to the control inputs of the fourth and sixth and switches, respectively, the combined information inputs of which form the information input of the check element calculator.

### BRIEF DESCRIPTION OF THE FIGURES

Fig. 1 illustrates an example of coding and decoding of an individual message.

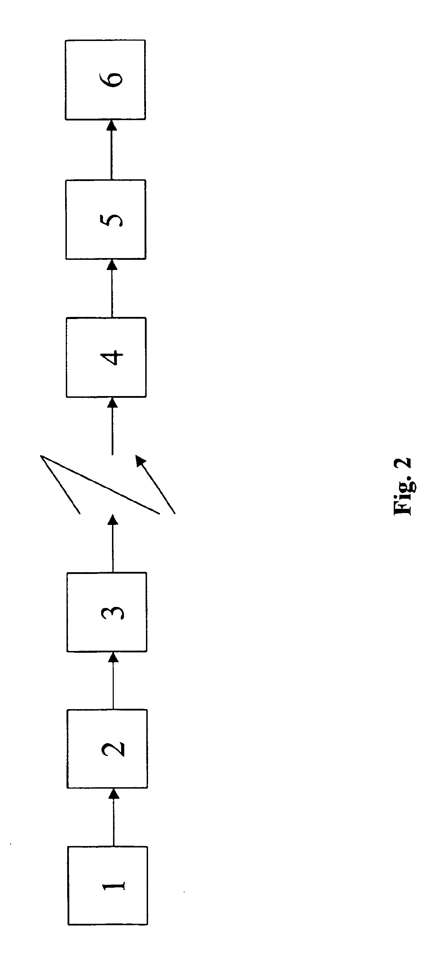

Fig. 2 illustrates an electrical block scheme of a system for transmitting a digital message.

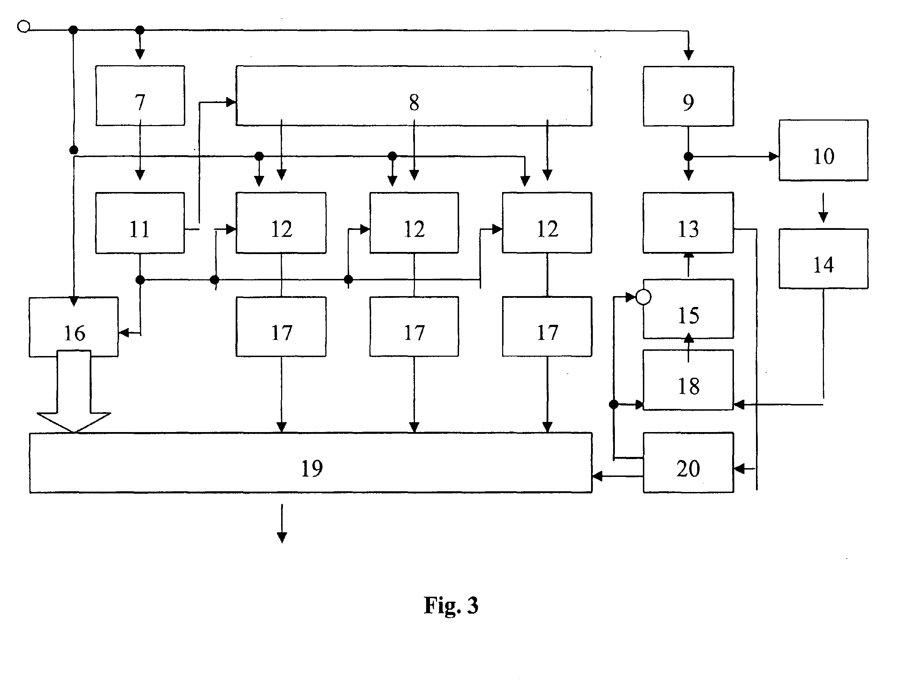

Fig. 3 illustrates an electrical block scheme of an encoder.

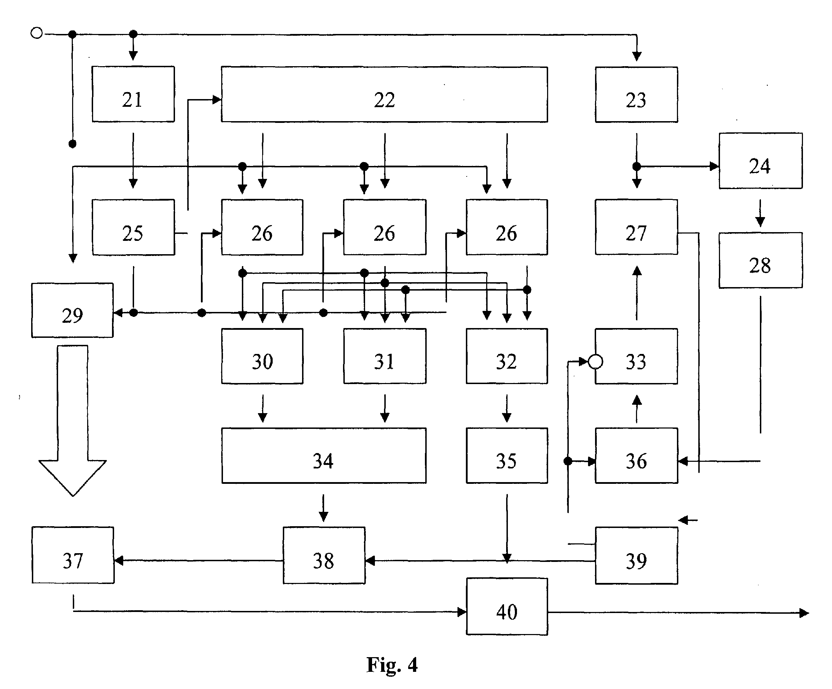

Fig. 4 illustrates an electrical block scheme of a decoder.

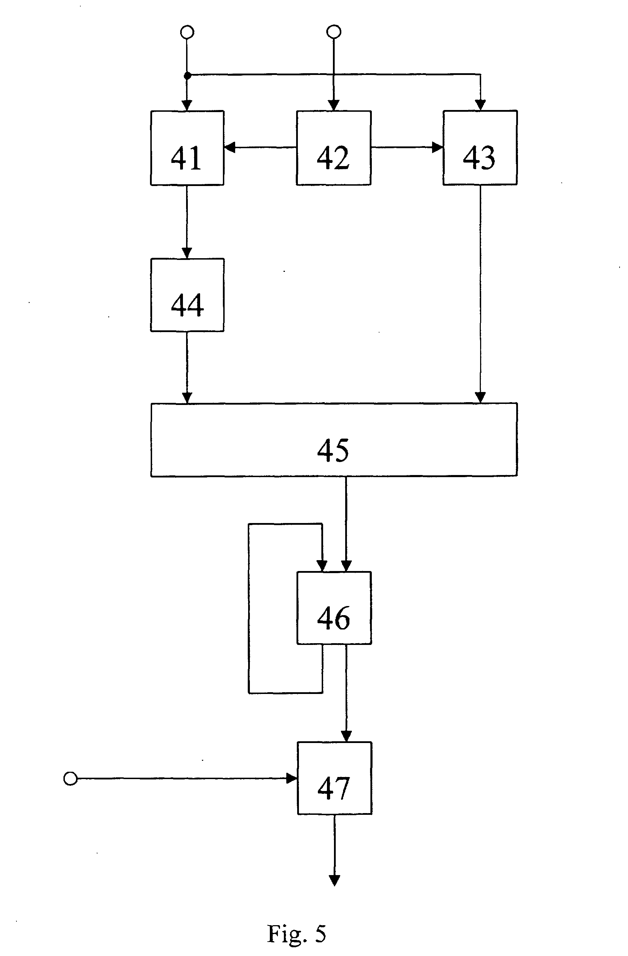

Fig. 5 illustrates an electrical block scheme of a check element calculator.

A system for transmitting a digital message consists of encoder 1, modulator 2, transmitter 3, receiver 4, demodulator 5 and decoder 6.

Encoder 1 comprises a first pulse shape forming unit 7, a memory unit 8 for storing operation codes of an additional operation matrix, a pulse generator 9 having recurrent frequency of fn/k, a first pulse recurrent frequency doubler 10, a first ring counter 11 up to k, a first group of m check element calculators 12, a first switch 13, a ring counter 14 up to (2k+1), a first gate AND 15, a first operative memory unit 16, m function g² calculators 17, a first trigger 18, a second operative memory unit 19 and a first ring counter 20 up to n.

Decoder 6 comprises a second pulse shape forming unit 21, a memory unit 22 for storing operation codes of a check matrix of operations, a pulse generator 23 having recurrent frequency of fk/(k+1), a second pulse recurrent frequency doubler 24, a second ring counter 25 up to n, a second group of m check element calculators 26, a second switch 27, a ring counter 28 up to [2(k+1)+1], a third operative memory unit 29, a unit 30 for making decisions on decoding, a unit 31 for making decisions on error correction, an error calculator 32, a second gate AND 33, a first gate OR, am (m+1)-th function g² calculator 35, a second trigger 36, a fourth operative memory unit 37, a third switch 38, a second ring counter 39 up to k, and an adder 40 for summing up Abelian group elements.

The calculator 12 (26) comprises a fourth switch 41, a decipher 42, a sixth switch 43, a function g² calculator 44, a second gate OR 45, an accumulating adder 46 for Abelian group elements, and a fifth switch 47.

### DESCRIPTION OF THE PREFERRED EMBODYMENT

The method for transmitting a digital message according to the invention is realized as follows:

A generating matrix of operations with k rows and n columns is produced. It consists of a k×k matrix with operations g⁰ at its diagonal and operations g¹ at other positions and an additional kxm matrix which is added to said kxk matrix at its right, non-repeated rows of which are sequences of operations g¹ and g⁰ or operations g¹ and g² chosen from any possible sequences which include not more than (m-2) operations g¹. It is also possible to use a generating matrix of operations produced from said generating matrix of operations by rearranging its rows and/or columns. The resulting generating matrix of operations is a matrix formed not of numbers, as usual matrixes, but of instructions to conduct a certain operation when an interaction with this element of the generating matrix of operations takes place.

Adding of an additional matrix is done in order to introduce into a message to be transmitted of check elements which serve to detect an error in the received message in cases when an error is generated in the process of message transmission through a communication channel, and to correct it if possible.

A digital message Xₖ is encoded by generalized matrix multiplication of the vector-row Xₖ by said generating matrix of operations G.

The procedure of the newly introduced operation of generalized matrix multiplication is similar to the procedure of usual matrix multiplication because it is performed in the same order, namely: paired interaction operations are done for the i-th element of the vector-row Xₖ and every ij-th element (which is situated at the crossing of the i-th row and the j-th column) of the operation matrix G and then the results of all i operations are summed up thus producing the j-th element of the vector-row Yₙ. Thereby, every of the above-mentioned operations which is required for the operation of generalized matrix multiplication is a summing operation in accordance with the rules formulated for elements of the Abelian group [2, p. 140], to which the elements of the generated digital message Xₖ consisting of k information elements belong. Operations g^{v} (g⁰, g¹ and g²) are summing operations with unity element of the group [2, p. 139], summing operations with the inverse element of the group [2, p. 140] and two-fold summing operations with the inverse element of the group, respectively.

The encoded message is modulated and transmitted to a communication channel.

The received message is demodulated and decoded by the operation of generalized matrix multiplication of a check matrix H by the transposed vector-row Y'ₙ^{T}.

The m×n check matrix of operations H is produced by transposing an additional matrix by adding at its right an m×m matrix with operations g⁰ on the diagonal and operations g¹ in other positions, if the rows of the additional matrix consist of a sequence of operations g¹ and g⁰, or in the same way save for exchanging operations g² for g⁰, if the rows of the additional matrix consists of a sequence of operations g¹ and g², and by rearranging the columns in the same way as the column rearrangement was done for the generating matrix of operations (if the generating matrix of operations was produced by column rearrangement).

Based on the analysis of the vector-column S^{T}ₘ formed as a result of decoding, a decision about error absence is made. If there is no more than one element different from unity element of the group in the vector-column S^{T}ₘ, elements corresponding by their numbers to the check matrix columns containing one operation g⁰ are excluded from the vector-row Y'ₙ; thus discarding the check elements introduced into the message during encoding.

If identical elements distinct from unity element are revealed in the vector-column S^{T}ₘ, this means that there is one error in the received message which is then corrected. For this, unity elements in the vector-column S^{T}ₘ are replaced by operations g¹ and other elements are replaced by operations g⁰. The resulting vector-column S^{T}ₘ is then compared with the columns of the matrix H and the number of the column identical to the vector-column S^{T}ₘ is determined. The conclusion is then made about the presence of an error in the symbol of the vector-row Y'ₙ having the number of the matrix H column identical to the vector-column S^{T}ₘ. The error is corrected by adding the erroneous symbol of the vector-row Y'ₙ to any element of the vector-column S^{T}ₘ which is inverse to any of elements distinct from unity element of the group (because in this case all elements of the vector-row S^{T}ₘ distinct from unity element of the group are identical).

If the message elements belong to a ring with unity, which is an individual case of additive Abelian group, operation g⁰ transforms into the operation of multiplication by unity, operation g¹ transforms into the operation of multiplication by zero and operation g² transforms into the operation of multiplication by minus unity.

If message elements belong to a residue class ring by modulo q, which is an individual case of a ring with unity, the operation ^{⊕}Σ transforms into the operation of summing by modulo q.

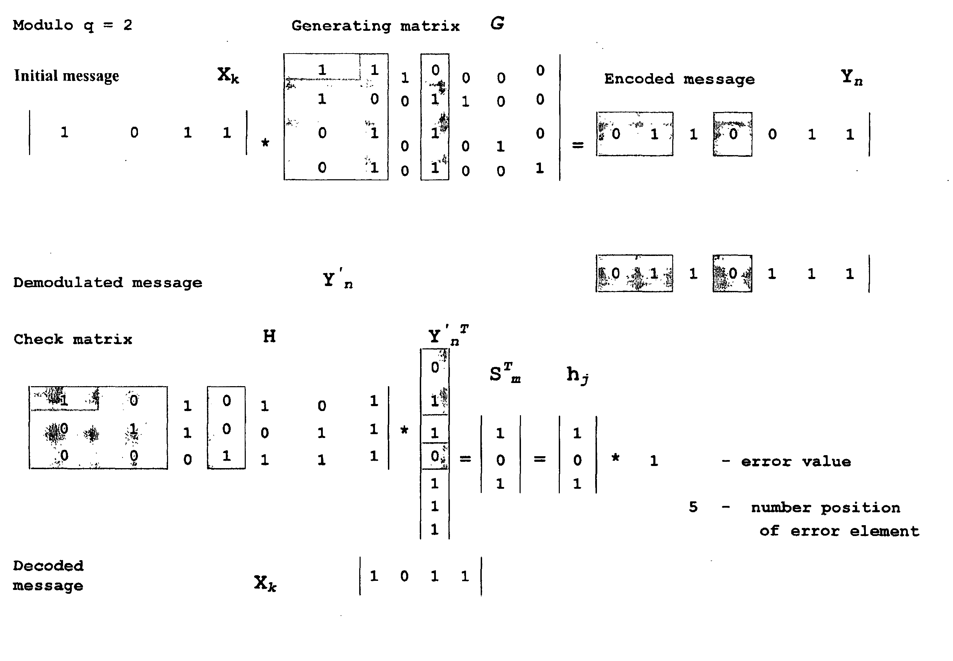

Fig. 1 illustrates an example of transmitting message Xₖ consisting of four digits. A generating matrix of operations G is produced according to the above-mentioned rule. Check columns are situated in the first, second and fourth positions. After generalized matrix multiplication of the vector-row Xₖ by the matrix G, the encoded message vector-row Yₙ with check element in the first, second and fourth positions is generated.

The demodulated message Y'ₙ is received with an error in the fifth position. Therefore, the result of the generalized matrix multiplication of the check matrix H by the transposed vector-row Y'ₙ is the vector-column S^{T}ₘ corresponding to the fifth column of the check matrix H. The decoding is then done by discarding the check elements, i.e. by extracting the elements of the original message and changing the fifth element by adding it to an inverse element of one of the non-unity elements in the vector-column S^{T}ₘ.

The system for transmitting a digital message according to the invention operates as follows:

Each element of the generated digital message Xₖ which consists of a sequence of code words with a size of k elements each, once reached the input of encoder 1 enters the information inputs of first operative memory unit 16 and first group of calculators 12, triggers first pulse shape forming unit 7 and synchronizes pulse generator 9.

The pulse from the output of first pulse shape forming unit 7 triggers first ring counter 11. While first ring counter 11 counts pulses at its input, the elements of the code word are being stored in the corresponding cells of first operative memory unit 16.

Each pulse counted by counter 11 transfers the operation code set of the corresponding row of the additional matrix from the output of memory unit 8 to the control inputs of the calculation algorithm of first group of calculators 12. These codes in each calculator 12 enter the inputs of decipher 42.

Depending on the type of the operation code entering decipher 42, this code opens the fourth switch allowing the element of the code word to pass to the output of accumulating adder 46, where this element is converted according to the rule g² and enters either the first input of the second gate OR, or the sixth switch, thus allowing the code word element to pass to the second input of the second gate OR and further to the input of accumulating adder 46.

In accumulating adder 46, every next element is summed up with the sum of the previous elements according to the rule for summing up Abelian group elements, thus forming a check element. After the k-th element of the code word enters the input of first ring counter 11, a pulse is formed at its overflow output which - by resetting first operative memory unit 16 - transfers the information from outputs of first operative memory unit 16 to the first k memory cells of second operative memory unit 19. At the same time, this pulse - once entered the reset inputs of the first group of m calculators 12 opens fifth switch 47 in each of them, thus transferring the previously formed sums to calculators 17, where the resulting values of the check elements are converted according to the rule g² and are stored in the memory cells from (k+1)-th to n-th of second operative memory unit 19.

Pulses from the output of generator 9 having recurrent frequency which is (k+1)/k times higher than the recurrent frequency of the code word elements, enter the information input of second switch 13, which, being originally in a closed state, does not transfer them to the input of first ring counter 20.

The same pulses enter the input of first frequency doubler 10, which doubles the recurrent frequency of the incoming pulses, and are then transferred from its output to the input of ring counter 14. With the entry of the (2k+1)-th pulse at the input of ring counter 14 (approximately in the middle of the time interval between the entry at the input of encoder 1 of the last element of the current code word and the first element of the next code word), a pulse from its overflow enters the counting input of first trigger 18, thereby changing its state.

The voltage signal "logical unity" formed at the output of first trigger 18 is transferred to the direct input of first gate AND 15. Since first ring counter 20 has not yet begun to count, the voltage signal "logical zero" is kept at its overflow output and consequently the voltage signal "logical unity" will appear at the output of first gate AND 15 which opens second switch 13.

The pulses from the output of generator 9 will begin to enter the input of first ring counter 20; and as a result thereof, a code will appear at its information output which will change with every next counted pulse. After entering the address input of second operative memory unit 19, this code will initiate an information reset of the memory cell having the same sequential number as the pulse counted by first ring counter 20, and k information and m check elements of the code word will be sequentially transferred to the input of modulator 2.

After the n-th pulse enters the input of first ring counter 20, the voltage signal "logical unity" will form at its overflow output, which will change the state of first trigger 18; and the voltage signal "logical zero" will appear at the output of first gate AND 15 which will close first switch 13 and stop the income of pulses from the output of generator 9 to the input of first ring counter 20, thus making it ready for the next operation cycle.

A modulated message from the output of modulator 2 enters the input of transmitter 3 and proceeds to a communication channel.

The received message, after being transferred through receiver 4, is demodulated in demodulator 5 and enters the input of decoder 6.

Each element of the received code word which enters the input of decoder 6 enters the information inputs of third operative memory unit 29 and second group of calculators 26, triggers second pulse shape forming unit 21 and synchronizes generator 23. The pulse from the output of second pulse shape forming unit 21 triggers second ring counter 25. Whereas second ring counter 25 counts pulses entering its input, the elements of the code word are stored in the corresponding cells of third operative memory unit 29. Each pulse counted by counter 25 transfers the operation code set of the corresponding column of the check matrix of operations from memory unit 22 to the calculation algorithm control inputs of second group of calculators 26. These codes are converted in each calculator 26 in the same manner as in calculators 12; and second adder-accumulator 22 determines the sum of all elements of the code word at its input according to the rule for summing Abelian group elements.

After the n-th element of the code word enters the input of second ring counter 25, a pulse is formed at its overflow output which - by resetting third operative memory unit 29-transfers the information from its outputs to the memory cells of fourth operative memory unit 37 and from the outputs of second group of calculators 26 to the inputs of unit 30 for making decisions, unit 31 for making decisions, and calculator 32.

If there is no error in the received message, a command is transferred from the output of unit 30 for making decisions to the control input of third switch 38, and the switch gets opened.

The pulses from the output of generator 23 having recurrent frequency which is k/n times lower than the recurrent frequency of the code word elements, enter the information input of second switch 27, which - being originally in a closed state - does not transfer these pulses to the input of second ring counter 39.

The same pulses enter the input of second frequency doubler 24, which doubles the recurrent frequency of the incoming pulses, and are then transferred from its output to the input of second ring counter 28. With the entry of the [2(k+1)+1]-th pulse at the input of ring counter 28 (approximately in the middle of the time interval between the entry at the input of decoder 6 of the last element of the current code word and the first element of the next code word), a pulse from its overflow output enters the counting input of second trigger 36, thereby changing its state.

The voltage signal "logical unity" formed at the output of second trigger 32 enters the direct input of second gate AND 33. Since second ring counter 39 has not yet begun to count, the voltage signal "logical zero" is kept at its overflow output and consequently the voltage signal "logical unity" will appear at the output of second gate AND 33 which opens second switch 27.

The pulses from the output of generator 23 will begin to enter the input of second ring counter 39; and as a result thereof, a code will appear at its information output, which will change with every next counted pulse. This code will pass through the already opened third switch 38 and - by entering the address input of fourth operative memory unit 37 - will initiate information reset of the cell with a sequential number corresponding to the number of the pulse counted by second ring counter 39; and k information elements of the code word will be sequentially transferred to the decoder output for non-correctable message. The check element will remain, since not required, in the memory cells of fourth operative memory unit 37 and will be replaced therein by the check element of the next code word.

After the k-th pulse enters the input of second ring counter 39, the voltage signal "logical unity" will form at its overflow output which will change the state of first trigger 36; and the voltage signal "logical zero" will appear at the output of second gate AND 33 which will close second switch 27 and stop the income of pulses from the output of generator 23 to the input of second ring counter 39, thus making it ready for the next operation cycle.

If there is an error in the received message, a command is transferred from the output of unit 31 for making decisions to the control input of third switch 38, which command opens the switch 38 and starts the calculator 32. Calculator 32 determines the value and the sequential number of the error in the received message and - after the pulse from the information output of the ring counter 39 enters the synchronization input of calculator 32 - sends an error signal to the input of calculator 35. In calculator 35, the error signal is converted according to the g² rule and gets summed up, in adder 40, with the corresponding element of the received message which has entered from the output of fourth memory unit 37, according to the rule for summing Abelian group elements; thus correcting the error and transferring the corrected message to the decoder output for correctable messages.

Unit 30 for making decisions, unit 31 for making decisions and calculator 32 can be realized as computer programs written in an algorithmic language, for example, QBASIC, and run on a typical microprocessor.

### A program for the realization of a unit 30 for making decisions:

The values of m elements of syndrome s at the outputs of the second group of m calculators 26 enter a memory area named DATA:
DATA s1, s2 ... sm.
The initial states of the memory cells:
erdecod$ = "decoding"
msg$ = ""
e = 0 "value code for the unity element"
none = e "initial value for a non-unity element"
countnone = 0 "counter for the number of non-unity elements"
m = 3; k = 4; n = k + m "parameters for a check matrix"
pozer = n + 1 "initial value of an error position pointer".
Organizing an area in the operative memory for the data set s:
DIM s(m).
Organizing an area in the operative memory for the data set of the check matrix h$:
DIM h$(m,n).
The values of the check matrix elements are stored in the memory area DATA:
DATA +e,+e,+e,-x+e,+e,+e,-x+e,+e,+e,-x
DATA +e,-x,-x,-x,+e,-x,-x,-x,+e.
Loading of m values of the syndrome elements into the operative memory:
FOR I = 1 TO m: READ s(i): NEXT i.
Loading of the check matrix into an operative memory:
FOR j = 1 TO n: FOR i = 1 TO m: READ h$(i,j): NEXT i: NEXT j.
Counting the number of non-unity elements in the syndrome and, if the number is zero, making a decision on decoding of the received message:
c = 0: FOR i = TO m: IF s(i) <> e THEN c = c + 1 NEXT i: countnone = c
IF countnone = 0 THEN msg$ = erdecod$
END.

A program for the realization of a unit 31 for making decisions:
The values for m elements of syndrome s at the outputs of the second group of m calculators 26 enter a memory area named DATA, which already contains the value of the number m:
DATA s1, s2 ... sm.
The initial states of the memory cells:
erdecod$ = "decoding"
msg$ = ""
e = 0 "value code for the unity element"
none = e "initial value for a non-unity element"
countnone = 0 "counter for counting non-unity elements"
m = 3; k = 4; n = k + m "parameters of a check matrix"
pozer = n + 1 "initial value for an error position pointer".
Organizing an area in the operative memory for the data set s:
DIM s(m).
Organizing an area in an operative memory for the data set of the check matrix h$:
DIM h$(m,n).
The values of the check matrix elements are stored in the memory area DATA:
DATA +e,+e,+e,-x,+e,+e,+e,-x,+e,+e,+e,-x
DATA +e,-x,-x,-x,+e,-x,-x,-x,+e,-x,-x,-x,+e.
Loading m values of the syndrome elements into the operative memory:
FOR i = 1 TO m: READ s(i): NEXT i.
Loading the check matrix into the operative memory:
FOR j = 1 TO n: FOR i = 1 TO m: READ h$(i,j): NEXT i: NEXT j.
Counting the number of non-unity elements in the syndrome and, if the number is one, making a decision on decoding of the received message:
c = 0: FOR i = 1 TO m: IF s(i) <> e THEN c = c + 1 NEXT i: countnone = c
IF countnone = 1 THEN msg$ = erdecod$
END.

A program for the realization of a calculator 32:
The values of m elements of syndrome s from the outputs of the second group of m calculators 26 enter a memory area named DATA:
DATA s1, s2 ... sm.
The initial states of the memory cells:
erdecod$ = "decoding"
mgs$ = ""
c = 0 "a value code for a unity element"
none = e "an initial value for a non-unity element"
countnone = 0 "a counter for counting non-unity elements"
m = 3; k = 4; n = k + m "parameters of a check matrix"
pozer = n + 1 "an initial value for an error position pointer".
Organizing an area in the operative memory for the data set s:
DIM s(m).
Organizing an area in the operative memory for the data set of the check matrix h$:
DIM h$(m,n).
The values of the elements of the check matrix are stored in the memory area DATA:
DATA +e,+e,+e,-x,+e,+e,+e,-x,+e,+e,+e,-x
DATA +e,-x,-x,-x,+e,-x,-x,-x,+e.
Loading m values of the syndrome elements into the operative memory:
FOR i = 1 TO m: READ s(i): NEXT i.
Loading the check matrix into the operative memory:
FOR j = 1 TO n: FOR i = 1 TO m: READ h$(I,j): NEXT i: NEXT j.
Calculating the first non-unity element in the syndrome:
FOR i = 1 TO m
IF s(i) = e THEN GOTO nxi:
none = s(i).
Checking other non-unity elements for their identity with the first element and, in a case of their identity, calculation of the error and its position number in the received message:
FOR j = i + 1 TO m
IF s(j) = e THEN GOTO nxj
IF s(j) = none THEN GOTO nxj
GOTO mout1
nxj: NEXT j
nxi: NEXT i.
Calculation of the parameter pozer - the position number for the error in the received message:
FOR j = 1 TO k
pozer = j
FOR i = 1 TO m
IF s(i) = none AND h$(i,j) = "+e" OR s(i) = e AND h$(i,j) = "-x" THEN p = 1
ELSE p = 0
ENF IF
IF p = 0 THEN GOTO nj
NEXT i
IF p = 1 THEN GOTO mout1
nj: NEXT j.
Storing the error value in the memory cell named none and its number in the received message in the memory cell named pozer:
mout1:
END.

### LITERATURE

1. J. Clark, J. Cane. Coding with error correction in digital communication systems, from English by S. I. Gelfand, ed. B. S. Tsybakov, Issue 28, Moscow, Publisher "Radio i svyaz", 1987. p.p. 9-18, fig 1.2.
2. A. I. Kostrikin, Introduction into algebra, Moscow, Publisher "Nauka", 1977.

## Claims

1. Method for transmitting a digital message, consisting of additive Abelian group elements, which method comprises consequent steps of encoding the message, its modulation, its transmission into a communication channel, demodulation of the received signal and its decoding, **characterized in that** the encoding is done according to the rule Yₙ =Xₖ⊗G, where
Xₖ is vector-row of the initial message consisting of k information elements,
Yₙ is vector-row of the encoded message consisting of k information and m check elements, where m is the smallest integer not less than log ₂ n, n = k+m,
G is generating matrix of operations which consists of k rows and n columns and is produced from a k×k matrix, with operations g⁰ at the diagonal and operations g¹ at other positions, and an additional kxm matrix added to the kxk matrix at its right, non-repeated rows of which are sequences of operations g¹ and g⁰ or operations g¹ and g² chosen from any possible sequences which include not more than (m-2) operations g¹, or a matrix obtained from said generating matrix of operations by rearranging its rows and/or columns,
⊗ is operation of generalized matrix multiplication according to the rule: yⱼ=^{⊕}Σg^{v}ᵢⱼ(xᵢ) for j≤k and yⱼ=g²[^{⊕}Σ g^{v}ᵢⱼ(xᵢ)] for j>k, if the rows of the additional matrix are sequences of operations g¹ and g⁰, or according to the rule: yⱼ=^{⊕}Σg^{v}ᵢⱼ(xᵢ), if the rows in the additional matrix are sequences of operations g¹ and g², where
yⱼ is j-th element of the vector-row for the encoded message,
^{⊕}Σ g^{v}₁ⱼ(x₁) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for ij-th matrix element,
v = [0, 2], i=[1, k], j=[1, n],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoding of the message Y'ₙ is done by excluding from the vector-row Y'ₙ of the elements which correspond by their numbers to the columns of the check matrix of operations H with one operation g⁰, provided that there is not more than one element, not equal e, in the vector-column S^{T}ₘ produced according to the rule: S^{T}ₘ=H⊗Y'ₙ^{T}, where
Y'ₙ^{T} is transposed vector-row Y'ₙ, and
H is m×n check matrix of operations produced by transposition of an additional matrix, by adding at its right an m×m matrix with operations g⁰ at its diagonal and operations g¹ at other positions, and by rearranging columns identically to the column rearrangement of the generating matrix of operations, if the rows of the additional matrix are sequences of operations g¹ and g⁰, or in the same way save for changing operations g² for operations g⁰, if the rows of the additional matrix are sequences of operations g¹ and g².

2. The method according to claim 1, **characterized in that** the value of the j-th symbol of the vector-row Y'ₙ is changed by adding it to the inverse element of one of the elements, not equal e, in the vector-column S^{T}ₘ, provided that all elements, not equal e, of the vector-column S^{T}ₘ are identical, and the vector-column S^{T}ₘ converted by changing said elements for operation g⁰ and all other elements for operation g¹, corresponds to the j-th column of the matrix H.

3. The method according to claim 1 or 2, **characterized in that** under the condition that the message elements belong to a ring with unity, operation ^{g0} is multiplication by unity, operation g¹ is multiplication by zero and operation g² is multiplication by minus unity.

4. The method according to any one of claims 1 to 3, **characterized in that** under the condition that the message elements belong to a residue class ring by modulo q, where q is a natural number, operation ⊕ is the operation of summing by modulo q.

5. A system for transmitting a digital message, consisting of additive Abelian group elements, which system comprises consecutively connected at the transmitting side an encoder, the input of which corresponds to the system's input, a modulator and a transmitter, and consecutively connected at the receiving side a receiver, a demodulator and a decoder, the output of which corresponds to the system's output, **characterized in that** the encoder is in a form capable of performing the algorithm Yₙ=Xₖ⊗G, where
Xₖ is vector-row of the initial message consisting of k information elements,
Yₙ is vector-row of the encoded message consisting of k information and m check elements, where m is the smallest integer not less than log ₂ n, n = k+m,
G is generating matrix of operations which consists of k rows and n columns and is produced from a k×k matrix, with operations g⁰ at the diagonal and operations g¹ at other positions, and an additional kxm matrix added to the k×k matrix at its right, non-repeated rows of which are sequences of operations g¹ and g⁰ or operations g¹ and g² chosen from any possible sequences which include not more than (m-2) operations g¹, or a matrix obtained from said generating matrix of operations by rearranging its rows and/or columns,
⊗ is operation of generalized matrix multiplication according to the rule: yⱼ=^{⊕}Σg^{v}ᵢⱼ(xᵢ) for j≤k and yⱼ=g²[^{⊕}Σ g^{v}ᵢⱼ(xᵢ)] for j>k, if the rows of the additional matrix are sequences of operations g¹ and g⁰, or according to the rule: yⱼ=^{⊕}Σg^{v}ᵢⱼ(xᵢ), if the rows in the additional matrix are sequences of operations g¹ and g², where
yⱼ is j-th element of the vector-row for the encoded message,
^{⊕}Σ g^{v}ᵢⱼ(xᵢ) = g^{v}₁ⱼ(x₁) ⊕ g^{v}₂ⱼ(x₂) ⊕ ... ⊕ g^{v}ₖⱼ(xₖ),
⊕ is operation for summing up Abelian group elements,
g^{v}ᵢⱼ(xᵢ) is operation g^{v} for element xᵢ according to the rule for ij-th matrix element,
v = [0, 2], i=[1, k], j=[1, n],
g⁰ = xᵢ ⊕ e, g¹ = xᵢ ⊕ (-xᵢ), g² = xᵢ ⊕ (-xᵢ) ⊕ (-xᵢ),
e is unity element of Abelian group,
and the decoder is in a form which provides for the exclusion from the vector-row Y'ₙ of elements which correspond by their numbers to the columns of the check matrix of operations H with one operation g⁰, provided that there is not more than one element, not equal e, in the vector-column S^{T}ₘ produced according to the rule: S^{T}ₘ=H⊗Y'ₙ^{T}, where
Y'ₙ^{T} is transposed vector-row Y'ₙ, and
H is m×n check matrix of operations produced by transposition of an additional matrix, by adding at its right an m×m matrix with operations g⁰ at its diagonal and operations g¹ at other positions, and by rearranging columns identically to the column rearrangement of the generating matrix of operations, if the rows of the additional matrix are sequences of operations g¹ and g⁰, or in the same way save for changing operations g² for operations g⁰, if the rows of the additional matrix are sequences of operations g¹ and g².

6. The system for transmitting a digital message according to the claim 5, **characterized in that** the decoder is in a form capable of changing the value of the j-th symbol of the vector-row Y'ₙ by adding it to an inverse element of one of the elements, not equal e, in the vector-column S^{T}ₘ, before the exclusion from the vector-row Y'ₙ of elements corresponding by their numbers to the columns of the check matrix of operations H, provided that all elements, not equal e, of the vector-column S^{T}ₘ are identical, and the vector-column S^{T}ₘ converted by changing said elements for operation g⁰ and all other elements for operation g¹, corresponds to the j-th column of the matrix H.

7. The system for transmitting a digital message according to claim 5 or 6, **characterized in that** the encoder contains:
• the first operative memory unit, k outputs of which are connected to the corresponding first k information inputs of the second operative memory unit, the output of which forms the encoder output,
• a memory unit for operation codes of the generating matrix of operations,
• the first group of m check element calculators, the calculation algorithm control inputs of which are connected to the m corresponding outputs of the memory unit for operation codes of the generating matrix of operations,
• m function g² calculators connected between the corresponding outputs of the first group of m check element calculators and the corresponding (k+1)-th to n-th information inputs of the second operative memory unit,
• consecutively connected the first pulse shape forming unit and the first ring counter up to k, the information input of which is connected to the matrix row address input of the memory unit for operation codes of the generating matrix of operations, and the overflow output of which is connected to the reset inputs of the first operative memory unit and the first group of m check element calculators,
• consecutively connected a pulse generator having recurrent frequency of fn/k, the first switch and the first ring counter up to n, the information output of which is connected to the address input of the second operative memory unit,
• the first gate AND, the output of which is connected to the control input of the first switch,
• the first trigger, the output of which is connected to the direct input of the first gate AND, the inverting input of which is connected with the overflow output of the first ring counter up to n and to the reset input of the first trigger,
• consecutively connected the first pulse recurrent frequency doubler, the input of which is connected to the output of the pulse generator having recurrent frequency of fn/k, and a ring counter up to (2k+1), the overflow output of which is connected to the counting input of the first trigger,
and that the combined inputs of the first operative memory unit and the check element calculators of the first group of m check element calculators, the start input of the pulse shape forming unit and the synchronization input of the pulse generator having recurrent frequency of fn/k together form the encoder input, whereby f is the recurrent frequency of the elements of a digital message.

8. The system for transmitting a digital message according to any one of claims 5 to 7, **characterized in that** the decoder contains:
• the third operative memory unit, the n outputs of which are connected to the n corresponding information inputs of the fourth operative memory unit, the output of which forms the decoder output for a non-correctable message,
• a memory unit for operation codes of the generating matrix of operations,
• the second group of m check element calculators, the calculation algorithm control inputs of which are connected to the m corresponding outputs of the memory unit for operation codes of the generating matrix of operations,
• consecutively connected the second pulse shape forming unit and the second ring counter up to n, the information input of which is connected to the address input of the memory unit for operation codes of the generating matrix of operations, and the overflow output of which is connected to reset inputs of the third operative memory unit and check element calculators of the second group of m check elements calculators,
• consecutively connected a pulse generator with recurrent frequency of fk/n, the second switch, the second ring counter up to k and the third switch, the information output of which is connected to the address input of the fourth operative memory unit,
• a unit for making decisions on decoding, the m inputs of which are connected to the outputs of the corresponding check element calculators of the second group of m check element calculators, and the output of which is connected to the control input of the third switch,
• the second gate AND, the output of which is connected to the control input of the second switch,
• the second trigger, the output of which is connected to the direct input of the second gate AND, the inverting input of which is connected to the overflow output of the second ring counter up to k and to the reset input of the second trigger,
• consecutively connected the second pulse recurrent frequency doubler, the input of which is connected to the output of the pulse generator having recurrent frequency of fk/n, and the ring counter up to [(2(k+1)+1], the overflow output of which is connected to the counting input of the second trigger,
and the combined inputs of the third operative memory unit and check element calculators of the second group of m check element calculators, the start input of the second pulse shape forming unit and the synchronization input of the pulse generator having recurrent frequency of fk/n together form the decoder input.

9. The system for transmitting a digital message according to claim 8, **characterized in that** the output of the unit for making decisions on decoding is connected to the control input of the third switch through the first gate OR and that it is provided a unit for making decisions on error correction, the output of which is connected to the second input of the first gate OR, consecutively connected an error calculator, the start input of which is connected to the output of the unit for making decisions on error correction and the writing input of which is connected to the overflow output of the second ring counter up to k, a function g² calculator and an adder for summing up Abelian group elements, the second input of which is connected to the output of the fourth operative memory unit and the output of which forms the correctable message output of the detector, and by providing that m inputs of the unit for making decisions on error correction and m inputs of the error calculator are connected to the outputs of the corresponding check element calculators of the second group consisting of m such calculators.

10. The system for transmitting a digital message according to any one of claims 7 to 9, **characterized in that** the check element calculator contains consecutively connected the fourth switch, a function g¹ calculator, the second gate OR, an accumulating adder of Abelian group elements, the output of which is connected to its second input and the fifth switch, the control input of which forms the reset input and the output of which forms the output of the check element calculator, the sixth switch, the output of which is connected to the second input of the first gate OR, a decipher, the input of which forms the calculation algorithm control input of the check element calculator and the outputs of which are connected to the control inputs of the fourth and sixth and switches, respectively, the combined information inputs of which form the information input of the check element calculator.
